# EUROPEAN PATENT SPECIFICATION

(11) **EP 3 361 847 B1**
(45) Date of publication and mention of the grant of the patent: **31.03.2021**
(21) Application number: 17155992.5
(22) Date of filing: 14.02.2017
(51) Int. Cl.: H05K 7/20

(54) **A HEAT EXCHANGER**
WÄRMETAUSCHER
ÉCHANGEUR DE CHALEUR

(43) Date of publication of application: 15.08.2018
(73) Proprietor: ABB Schweiz AG, 5400 Baden (CH)
(72) Inventor: Manninen, Jorma, 00380 Helsinki (FI); Kärppä, Jaani, 00380 Helsinki (FI); Kinnunen, Tuomo, 00270 Helsinki (FI)
(74) Representative: Kolster Oy Ab

(56) References cited:
- EP-A1- 0 390 053
- EP-A1- 2 988 578
- CN-A- 104 792 200
- US-A1- 2006 146 496
- US-A1- 2015 060 019

## Description

### FIELD OF THE INVENTION

The invention relates to a heat exchanger, and particularly to a heat exchanger comprising a plurality channels which are capillary dimensioned for a working fluid.

### BACKGROUND OF THE INVENTION

Power electronic components packed in a small volume generate a significant amount of heat and require a reliable and safe cooling system for dissipating the heat.

The compact size of power electric components demands also a compact size cooling system to fully utilize the obtained space savings in the components.

The thermal environment where the power electronic component is to operate sets limits to the cooling system. Even if the thermal environment is relatively stable the temperature of the available cooling media may be high.

US 2006/0146496 A1 discloses a cooling system employing a pulsating heat pipe for cooling a printed circuit board.

EP0 390 053 discloses a heat conducting interface apparatus for an electronic module.

EP 2 988 578 A1 discloses a cooling element for multiple electric devices which has a fluid channel arrangement providing a pulsating heat pipe behavior.

CN 104 792 200 A discloses a kind of pulsating heat pipe heat exchanger with lyophily coating.

### BRIEF DESCRIPTION OF THE INVENTION

An object of the present invention is to solve the above mentioned drawbacks.

The objects of the invention are achieved by a heat exchanger which is characterized by what is stated in the independent claim.

The preferred embodiments of the invention are disclosed in the dependent claims.

The invented heat exchanger provides a safe and reliable cooling system in a compact size which operates also on higher cooling liquid temperatures.

### BRIEF DESCRIPTION OF THE DRAWINGS

In the following the invention will be described in greater detail by means of preferred embodiments with reference to the attached drawings, in which
Figure 1 shows a perspective view of a heat exchanger;
Figure 2 shows a side view of a cross section of a heat exchanger;
Figure 3 shows heat flows in a heat exchanger oriented horizontally;
Figure 4 shows heat flows in a heat exchanger oriented vertically;
Figure 5 shows heat flows in a heat exchanger inclined vertically;
Figure 6 shows a side view of a cross section of a heat exchanger;
Figure 7 shows a side view of a cross section of a heat exchanger;
Figure 8 shows a side view of a cross section of a heat exchanger;
Figure 9 shows a flow path for a working fluid.

### DETAILED DESCRIPTION OF THE INVENTION

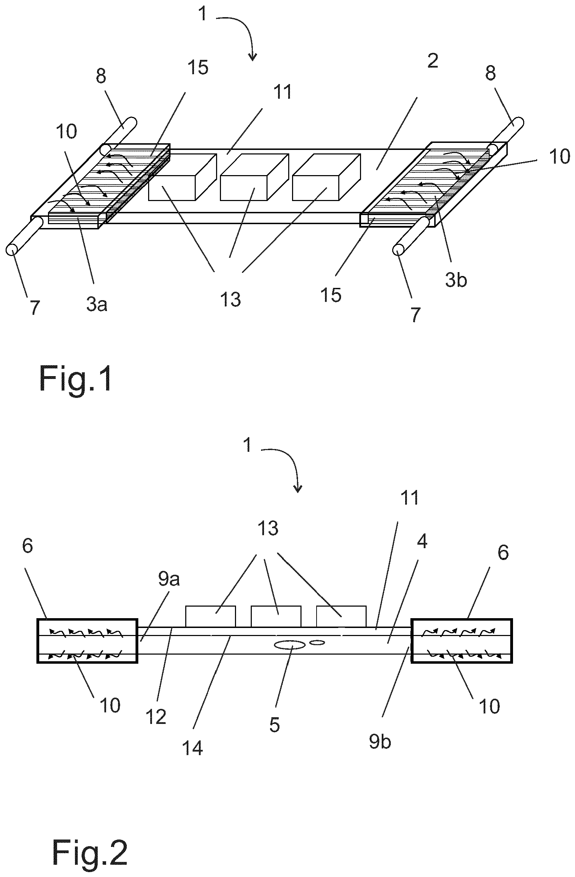

Figure 1 is a perspective view of a heat exchanger 1. The heat exchanger 1 comprises a heat input section 2 and two heat output sections 3a-b. The heat input section 2 and the heat output sections 3a-b comprise a plurality of channels 4. The plurality of channels 4 contain a working fluid 5 and provide a flow path for the working fluid 5 to move between the heat input section 2 and the heat output sections 3a-b. The plurality of channels 4 are capillary dimensioned for the working fluid 5. The first 3a and second 3b heat output sections comprise a cooling liquid chamber 6. The liquid cooling chamber 6 comprises an inlet 7 and an outlet 8 for cooling liquid. The first heat output section 3a and the second heat output section 3b are arranged on the first end 9a and the second end 9b of the heat input section 2. The plurality of channels 4 extend from the first heat output section 3a through the heat input section 2 to the second heat output section 3b.

The plurality of channels 4 have capillary dimensions. The plurality of channels 4 are capillary-sized, in which case they have a size small enough so that bubbles can grow uniquely in a longitudinal direction, i.e. in the longitudinal direction of the channel as opposed to the radial direction, and thereby create a pulsating effect by pushing the working liquid 5.

The diameter of a channel which is considered capillary depends on the working fluid 5 that is used and is boiling inside the channel. Examples of working fluids suitable for use in the heat exchanger are R134a (Tetrafluoroethane), R145fa and R1234ze (Tetrafluoropropene) and the respective diameter of the channel varies between 1 to 3 mm.

The plurality of channels 4 may be produced by dividing pipes into channels by internal walls of the pipes. Thus, each pipe contains several channels. The pipes or tubes may be Multi Port Extruded pipes, for instance.

The inlet 7 and the outlet 8 for cooling liquid may be arranged at opposite walls of the cooling liquid chamber 6 as shown in Figures 1-2. The plurality of channels 4 in the heat output section 3a-b can be arranged between the inlet 7 and outlet 8 so that the flow direction of the working fluid 5 in the plurality of channels 4 is transverse to the flow direction of the cooling liquid 10 flow. The cooling liquid 10 is shown with thin arrows in Figures 1-2. Thus the heat output section 3a-b operates then as a cross flow heat exchanger.

A pump may be used for moving the cooling liquid 10. The cooling liquid 10 can circulate in a closed loop where it transfers the heat received in the heat output section 3a-b to another media.

The heat input section 2 may comprise a base plate 11 as shown in Figures 1-2 and 6-8. The base plate 11 comprises a first surface 12 for receiving electronic components 13. A second surface 14 contacts walls of the plurality of channels 4 in order to transfer heat generated by the electronic components 13 to the working fluid 5 in the plurality of channels 4. The heat is conducted from the base plate 11 to the plurality of channels 4 containing the working fluid 5.

Further, the second surface 14 may comprise grooves into which the plurality of channels 4 can be arranged. The base plate 11 can basically consists of a block of a material with a good heat conductivity. Suitable materials include metals, such as aluminium, for instance. The same material or another material with good heat conductivity may be used for the plurality of channels 4.

The heat to the heat input section 2 is provided by electronic components 13. Electronic components 13 are often designed to dissipate the excess heat mainly via the electronic component's base plate. The electronic component's base plate is arranged in a good thermal connection with the heat input section 13 of the heat exchanger 1. An example of an electronic component 13 is an IGBT module of a power converter.

Figure 2 shows a side view of a cross section of a heat exchanger 1. The plurality of channels 4 in the heat output sections 3a-b may comprise fins 15 extending from the outer surface of the plurality of channels 4. The cooling liquid 10 flows between the fins 15. The fins 15 increase the heat transfer surface of the heat output section 3a-b but the fins 15 unavoidably increase the pressure drop and consequently increase the cooling liquid 10 pump power requirements to overcome the flow resistance in the heat output section 3a-b. However, as the heat output section 3a-b is liquid cooled the created back pressure is relatively low.

The cooling liquid chamber 6 preferably surrounds the plurality of channels 4 in the heat output section 3a-b providing a leak tight envelope. As a reliable construction is required a friction stir welding can be used to join the cooling liquid chamber 6 and the heat output section 3a-b.

The cooling liquid chamber 6 may comprise such a volume that the plurality of channels 4 in the heat output section 3a-b are immersed in a cooling liquid 10.

In the heat exchanger 1 adapted to operate as a Pulsating Heat Pipe the working fluid 5 is transported by means of differential pressure across liquid slugs and vapour slugs from the heat input section 2 to the heat output sections 3a-b and back from the heat output sections 3a-b to the heat input section 2. The Pulsating Heat Pipe involving a plurality of channels 4 having capillary dimensions, oscillations occur in a small channel loop heat pipe due to the bidirectional expansion of vapour inside the channels. During operation, the liquid slugs and elongated vapour bubbles will oscillate between a cold region, i.e. the heat output section 3a-b, and a hot region, i.e. the heat input section 2, because of hydrodynamic instabilities caused by the rapid expansion of the bubbles confined in the small channels, and thus provide a fluid velocity almost independent of gravity. Consequently, the heat exchanger 1 works in any orientation, without significant additional costs, and with a working fluid 5 volume that is smaller than in a conventional cooler, for instance in a liquid cold plate.

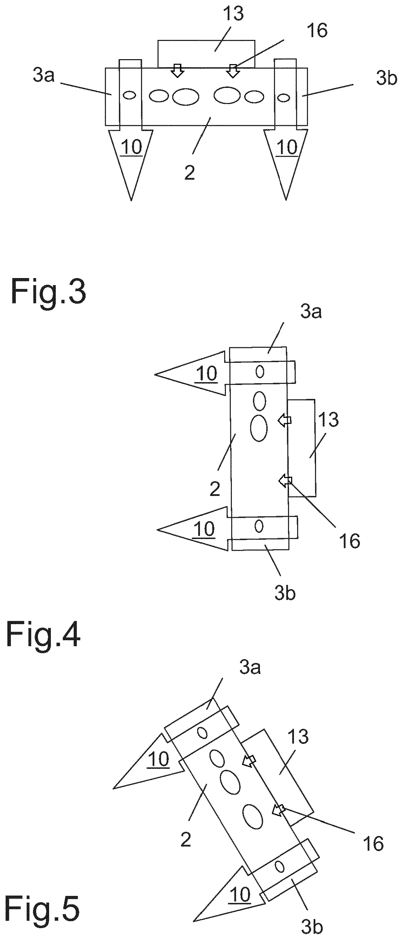

The heat flow directions in a heat exchanger 1 disposed vertically, horizontally and inclined vertically are shown in Figures 3-5. The advantage of the heat exchanger 1 is that it can be installed in any direction.

The large arrows in the Figures 3-5 present the cooling liquid 10 flow. The bubbles in the figures present the flow direction of the liquid slugs and the vapour slugs. The small arrows present the heat flow 16 from the electronic component 13 attached to the heat input section 2. As the heat output sections 3a-b are arranged on the both ends 9a-b of the heat input section 2 the heat exchanger 1 may be oriented freely.

The performance of the heat exchanger 1 changes depending on the orientation of the heat exchanger 1. In figure 3 the heat exchanger 1 is oriented horizontally. The liquid slugs and the vapour slugs oscillate between the heat input section 2 and both heat output section 3a-b substantially similarly.

In figure 4 the heat exchanger is oriented vertically. The liquid slugs and the vapour slugs oscillate mainly between the heat input section 2 and the first heat output section 3a which is positioned vertically higher.

In figure 5 the heat exchanger is inclined vertically. The liquid slugs and the vapour slugs oscillate more between the heat input section 2 and the first heat output section 3a which is positioned vertically higher than between the heat input section 2 and the second heat output section 3b which is positioned vertically lower.

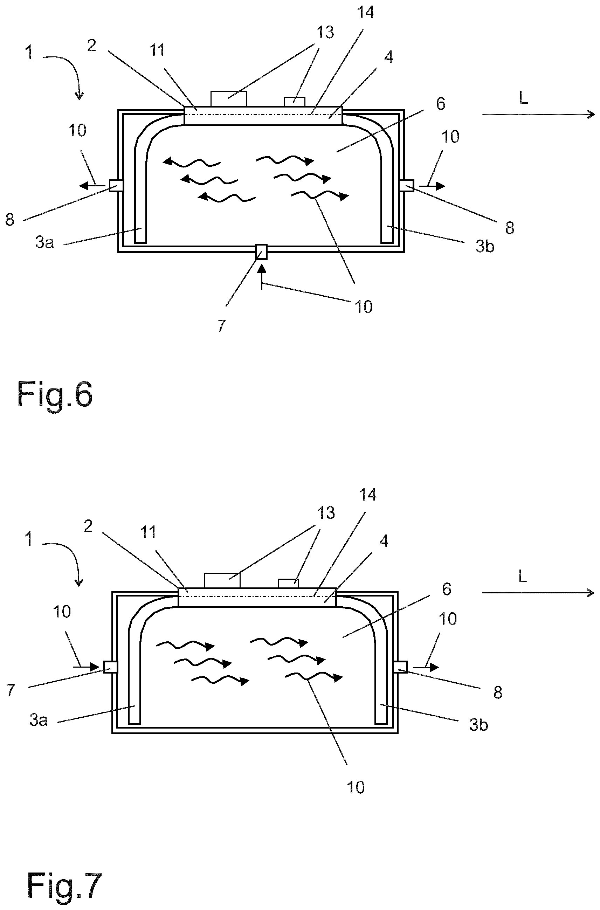

Figures 6 and 7 show a side view of a cross section of a heat exchanger 1. The heat input section 2 comprises a base plate 11 comprising more than one electronic components 13. A second surface 14 of baseplate 11 contacts the walls of the plurality of channels 4 in order to transfer heat generated by the electronic components 13 to the working fluid 5 in the plurality of channels 4.

As shown in Figures 6 and 7 the heat exchanger 1 may comprise a bended shape. The first heat output section 3a and the second heat output section 3b are bend away from the length direction L of the heat input section 2.

Further, the heat exchanger 1 may comprise a U-shape where the sides comprise the first heat output section 3a and the second heat output section 3b and the bottom comprises the heat input section 2.

The same cooling liquid chamber 6 surrounds the plurality of channels 4 in the first heat output section 3a and the second heat output section 3b. The first heat output section 3a and the second heat output section 3b have a common cooling liquid chamber 6 and the first heat output section 3a and the second heat output section 3b are cooled with a common cooling liquid 10. The cooling liquid 10 is shown with thin arrows in Figures 6-7.

In Figure 6 the cooling liquid inlet 7 in the cooling liquid chamber 6 is arranged between the first heat output section 3a and the second heat output section 3b. In the vicinity of the first heat output section 3a is arranged at least one cooling liquid outlet 8 in the cooling liquid chamber 6, and in the vicinity of the second heat output section 3b is arranged at least one cooling liquid outlet 8.

In Figure 7 in the vicinity of the first heat output section 3a is arranged at least one cooling liquid inlet 7 and in the vicinity of the second heat output section 3b is arranged at least one cooling liquid outlet 8.

The heat input section 2 may also be in a heat transfer contact with the cooling liquid 10. The plurality of channels 4 in the heat input section 2 can be arranged to receive heat through one surface of the plurality of channels 4, and the plurality of channels 4 in the heat input section 2 can be arranged to reject heat through another surface of the plurality of channels 4.

In Figures 6-7 the plurality of channels 4 in the heat input section 2 receive heat generated by the electronic components 13 through one surface of the plurality of channels 4. The one surface faces towards the heat source. The received heat is transferred to the working fluid 5 in the plurality of channels 4. The plurality of channels 4 in the heat input section 2 reject heat through another surface of the plurality of channels 4. The rejected heat is transferred from the working fluid 5 in the plurality of channels 4 to the cooling liquid 10. The another surface of the plurality of channels 4 faces towards the heat sink.

In the heat exchanger 1 construction shown in Figures 6-7 the heat input section 2 is in contact with the cooling liquid 10. The same construction may be used by adding an insulation between the heat input section 2 and the cooling liquid 10. The insulation prevents excessive cooling of the plurality of channels 4 in the heat input section 2, e.g. in the baseplate 11 region.

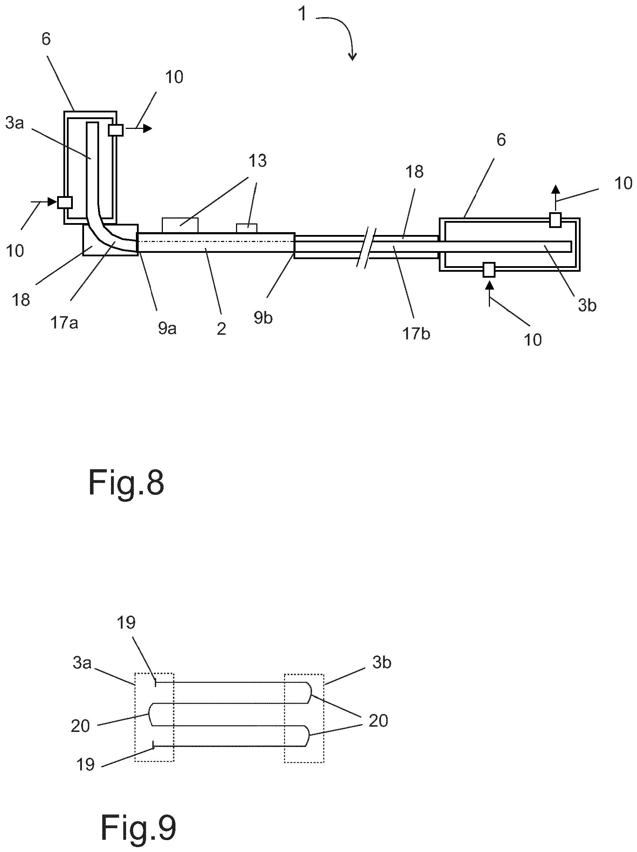

Figure 8 shows a side view of a cross section of a heat exchanger. The heat exchanger 1 comprises thermally insulated sections 17a-b which are thermally insulated from surroundings. The thermally insulated section or sections 17a-b are preferably arranged between the heat input section 2 and the heat output section or sections 3a-b. The thermally insulated section 17a-b allows spacing heat input section 2 and heat output section 3a-b at a distance apart from one another.

Figure 8 presents a first thermally insulated section 17a between the first heat output section 3a and the first end 9a of the heat input section 2. A second thermally insulated section 17b is positioned between the second heat output section 3b and the second end 9b of the heat input section 2. The thermally insulated sections 17a-b are provided with an insulation 18 around the heat exchanger 1 to minimize the heat transfer between the thermally insulated sections 17a-b and the surroundings.

As shown in Figure 8 the heat exchanger 1 may comprise a bended shape. The first heat output section 3a is bend away from the length direction L of the heat input section 2. The first heat output section 3a is bend towards the side of the heat exchanger 1 which comprises the heat generating components, i.e. electronic components 13.

Further, the heat exchanger 1 may comprise a L-shape where one side comprises the first heat output section 3a and the other side comprises the second heat output section 3b and the heat input section 2.

The cooling liquid chambers 6 in a heat exchanger 1 comprising a bended shape can have different dimensions and different positioning of cooling liquid inlets 7 and cooling liquid outlets 8 due to the non-symmetrical shape of the heat exchanger 1. In a heat exchanger 1 having a symmetrical shape it is often economical to manufacture similar liquid cooling chambers 6 to the heat output sections 3a-b.

The heat exchanger 1 may be adapted to operate with a closed working fluid 5 loop. In a closed working fluid 5 loop the ends 19 of the plurality of channels 4 are joined to each other to form a continuous loop where the working fluid 5 can circulate.

The heat exchanger 1 may be adapted to operate with an open working fluid 5 loop as shown in Figure 9. In an open working fluid 5 loop the ends 19 of the plurality of channels 4 are sealed to form a flow path where the working fluid 5 can move between the ends of the plurality of channels 4.

The plurality of channels 4 are preferably arranged to form a serpentine shaped flow path for the working fluid 5 having a number of turns 20, e.g. U-turns as shown in Figure 9. The number of turns 20 are preferably positioned in the two heat output sections 3a-b. The two heat output sections 3a-b are shown with a dotted line in Figure 9.

The plurality of channels 4 may also be arranged to form a substantially direct flow path from the first heat output section 3a through the heat input section 2 to the second heat output section 3b, where the flow path has no bends or bends are less than or equal to 90°.

The heat exchanger 1 adapted to operate as a pulsating heat pipe provided with a liquid cooled heat output sections 3a-b is suitable for a harsh environment. For example, possible applications are cooling of drive modules for heavy hybrid or full electric vehicles and marine applications. If the heat exchanger 1 is used in a vehicle the cooling liquid 10 may comprise engine oil. Engine oil is often already present as a motor cooling liquid and as a lubricant in vehicles, so no extra coolant tanks, pumps nor radiators are required.

The heat exchanger 1 has a compact size as the two phase working fluid 5 and liquid cooling allow an effective heat transfer. Thus the heat exchanger 1 is suitable for cooling power electronic components 13 having a high heat dissipation rate.

The heat exchanger 1 provided with a liquid cooled heat output sections 3a-b is capable of operating on higher cooling liquid 10 temperatures 50..100°C.

The heat exchanger 1 adapted to operate as a pulsating heat pipe tolerates peak loading better than conventional heat pipes. The pulsating heat pipe heat exchanger 1 allows high vapour slug formation percentage.

Part list: 1 a heat exchanger; 2 a heat input section; 3a-b a first and a second heat output section; 4 a plurality of channels; 5 a working fluid; 6 a cooling liquid chamber; 7 a cooling liquid inlet; 8 a cooling liquid outlet; 9a-b a first end and a second end; 10 a cooling liquid; 11 a base plate; 12 a first surface; 13 an electronic component; 14 a second surface; 15 a fin; 16 a heat flow; 17a-b a first and a second thermally insulated section; 18 an insulation; 19 an end of the plurality of channels; 20 a turn, L length direction.

## Claims

1. A heat exchanger (1) comprising
a heat input section (2) having a first end (9a) and a second, opposite end (9b), the heat input section (2) comprising a base plate (11) having a first surface (12) for receiving electronic components (13) and a second opposite surface (14),
a first heat output section (3a) at the first end (9a) of the heat input section (2),
a second heat output section (3b) at the second end (9b) of the heat input section (2),
a plurality of channels (4) extending from the first heat output section (3a) through the heat input section (2) to the second heat output section (3b), the plurality of channels (4) providing a flow path for a working fluid (5) to move between the heat input section (2) and the two heat output sections (3a-b), the plurality of channels (4) being capillary dimensioned for the working fluid (5), walls of the plurality of channels (4) contacting the second surface (14) of the base plate (11),
**characterized in that**
the plurality of channels (4) is formed of pipes being divided into channels (4) by internal walls of the pipes,
each heat output section (3a-b) comprises a cooling liquid chamber (6) surrounding the plurality of channels (4) in the heat output section (3a-b),
each cooling liquid chamber (6) comprises an inlet (7) and an outlet (8) for cooling liquid (10) to provide a liquid cooled heat output section (3a-b),
the inlet (7) and the outlet (8) for cooling liquid (10) are arranged at opposite walls of the cooling liquid chamber (6), wherein the plurality of channels (4) in the heat output section (3a-b) are arranged between the inlet (7) and outlet (8) to make the heat output section (3a-b) operate as a cross flow heat exchanger.

2. The heat exchanger according to claim 1, **characterized in that** the plurality of channels (4) in the heat output sections (3a-b) comprise fins (15) extending from the outer surface of the plurality of channels (4).

3. The heat exchanger according to claim 1 or 2, **characterized in that** the heat exchanger (1) is adapted to operate as a pulsating heat pipe.

4. The heat exchanger according to any of claims 1-3, **characterized in that** the heat exchanger (1) is adapted to operate with a closed working fluid (5) loop.

5. The heat exchanger according to any of claims 1-3, **characterized in that** the heat exchanger (1) is adapted to operate with an open working fluid (5) loop.

6. The heat exchanger according to any of claims 1-5, **characterized in that** the plurality of channels (4) are arranged to form a serpentine shaped flow path for the working fluid (5) having a number of turns (20), and the number of turns (20) are positioned in the two heat output sections (3a-b).

7. The heat exchanger according to any of claims 1-6, **characterized in that** the heat exchanger (1) comprises a bended shape, wherein at least one of the first heat output section (3a) and the second heat output section (3b) is bend away from the length direction (L) of the heat input section (2).

8. The heat exchanger according to any of claims 1-7, **characterized in that** the plurality of channels (4) in the heat input section (2) are arranged to receive heat through one surface of the plurality of channels (4), and the plurality of channels (4) in the heat input section (2) are arranged to reject heat through another surface of the plurality of channels (4).

9. The heat exchanger according to any of claims 1-8, **characterized in that** the heat exchanger (1) comprises a first thermally insulated section (17a) between the first heat output section (3a) and the first end (9a) of the heat input section (2) and/or a second thermally insulated section (17b) between the second heat output section (3b) and the second end (9b) of the heat input section (2).

10. Use of the heat exchanger according to any of claims 1-9 in a vehicle, **characterized in that** the cooling liquid (10) comprises engine oil.

## Patentansprüche

1. Wärmetauscher (1), umfassend
einen Wärmeeingabeabschnitt (2) mit einem ersten Ende (9a) und einem zweiten, gegenüberliegenden Ende (9b), wobei der Wärmeeingabeabschnitt (2) eine Grundplatte (11) mit einer ersten Oberfläche (12) zum Aufnehmen von elektronischen Bauteilen (13) und einer zweiten, gegenüberliegenden Oberfläche (14) aufweist,
einen ersten Wärmeausgabeabschnitt (3a) am ersten Ende (9a) des Wärmeeingabeabschnitts (2),
einen zweiten Wärmeabgabeabschnitt (3b) am zweiten Ende (9b) des Wärmeeingabeabschnitts (2),
eine Vielzahl von Kanälen (4), die sich aus dem ersten Wärmeabgabeabschnitt (3a) durch den Wärmeeingabeabschnitt (2) zum zweiten Wärmeabgabeabschnitt (3b) erstrecken, wobei die Vielzahl von Kanälen (4) einen Strömungsweg für ein Arbeitsfluid (5) bereitstellt, um sich zwischen dem Wärmeeingabeabschnitt (2) und den beiden Wärmeabgabeabschnitten (3a-b) zu bewegen, wobei die Vielzahl von Kanälen (4) kapillar für das Arbeitsfluid (5) dimensioniert sind, wobei Wände der Vielzahl von Kanälen (4) die zweite Oberfläche (14) der Grundplatte (11) kontaktieren,
**dadurch gekennzeichnet, dass**
die Vielzahl von Kanälen (4) aus Rohren gebildet ist, die durch Innenwände der Rohre in Kanäle (4) unterteilt sind,
jeder Wärmeabgabeabschnitt (3a-b) eine Kühlflüssigkeitskammer (6) umfasst, die die Vielzahl von Kanälen (4) in dem Wärmeabgabeabschnitt (3a-b) umgibt,
jede Kühlflüssigkeitskammer (6) einen Einlass (7) und einen Auslass (8) für Kühlflüssigkeit (10) umfasst, um einen flüssigkeitsgekühlten Wärmeabgabeabschnitt (3ab) bereitzustellen,
der Einlass (7) und der Auslass (8) für Kühlflüssigkeit (10) an gegenüberliegenden Wänden der Kühlflüssigkeitskammer (6) angeordnet sind, wobei die Vielzahl von Kanälen (4) in dem Wärmeabgabeabschnitt (3ab) zwischen dem Einlass (7) und dem Auslass (8) angeordnet sind, um den Wärmeabgabeabschnitt (3a-b) als einen Kreuzstromwärmetauscher arbeiten zu lassen.

2. Wärmetauscher gemäß Anspruch 1, **dadurch gekennzeichnet, dass** die Vielzahl von Kanälen (4) in den Wärmeabgabeabschnitten (3a -b) Rippen (15) aufweisen, die sich von der Außenfläche der Vielzahl von Kanälen (4) erstrecken.

3. Wärmetauscher gemäß Anspruch 1 oder 2, **dadurch gekennzeichnet, dass** der Wärmetauscher (1) zum Betrieb als pulsierendes Wärmerohr eingerichtet ist.

4. Wärmetauscher gemäß einem der Ansprüche 1-3, **dadurch gekennzeichnet, dass** der Wärmetauscher (1) zum Betrieb mit einem Arbeitsfluid (5) in einem geschlossenen Kreislauf eingerichtet ist.

5. Wärmetauscher gemäß einem der Ansprüche 1-3, **dadurch gekennzeichnet, dass** der Wärmetauscher (1) für den Betrieb mit einem Arbeitsfluid (5) in einem offenen Kreislauf eingerichtet ist.

6. Wärmetauscher gemäß einem der Ansprüche 1-5, **dadurch gekennzeichnet, dass** die Vielzahl von Kanälen (4) so angeordnet sind, dass sie einen serpentinenförmigen Strömungsweg für das Arbeitsfluid (5) bilden, der eine Anzahl von Windungen (20) aufweist, und dass die Anzahl von Windungen (20) in den beiden Wärmeabgabeabschnitten (3a-b) angeordnet sind.

7. Wärmetauscher gemäß einem der Ansprüche 1-6, **dadurch gekennzeichnet, dass** der Wärmetauscher (1) eine gebogene Form aufweist, wobei mindestens einer des ersten Wärmeabgabeabschnitts (3a) und des zweiten Wärmeabgabeabschnitts (3b) von der Längsrichtung (L) des Wärmeeingabeabschnitts (2) weg gebogen ist.

8. Wärmetauscher gemäß einem der Ansprüche 1-7, **dadurch gekennzeichnet, dass** die Vielzahl von Kanälen (4) im Wärmeeingabeabschnitt (2) so angeordnet sind, dass sie über eine Oberfläche der Vielzahl von Kanälen (4) Wärme aufnehmen, und dass die Vielzahl von Kanälen (4) im Wärmeeingabeabschnitt (2) so angeordnet sind, dass sie durch eine andere Oberfläche der Vielzahl von Kanälen (4) Wärme abweisen.

9. Wärmetauscher gemäß einem der Ansprüche 1-8, **dadurch gekennzeichnet, dass** der Wärmetauscher (1) einen ersten wärmeisolierten Abschnitt (17a) zwischen dem ersten Wärmeabgabeabschnitt (3a) und dem ersten Ende (9a) des Wärmeeingabeabschnitts (2) und/oder einen zweiten wärmeisolierten Abschnitt (17b) zwischen dem zweiten Wärmeabgabeabschnitt (3b) und dem zweiten Ende (9b) des Wärmeeingabeabschnitts (2) aufweist.

10. Verwendung des Wärmetauschers gemäß einem der Ansprüche 1-9 in einem Fahrzeug, **dadurch gekennzeichnet, dass** die Kühlflüssigkeit (10) Motoröl umfasst.

## Revendications

1. Échangeur de chaleur (1), comprenant
une section d'entrée de chaleur (2) ayant une première extrémité (9a) et une seconde extrémité opposée (9b), la section d'entrée de chaleur (2) comprenant une plaque de base (11) ayant une première surface (12) pour recevoir des composants électroniques (13) et une seconde surface opposée (14),
une première section de sortie de chaleur (3a) à la première extrémité (9a) de la section d'entrée de chaleur (2),
une seconde section de sortie de chaleur (3b) à la seconde extrémité (9b) de la section d'entrée de chaleur (2),
une pluralité de canaux (4) s'étendant depuis la première section de sortie de chaleur (3a) à travers la section d'entrée de chaleur (2) jusqu'à la seconde section de sortie de chaleur (3b), la pluralité de canaux (4) fournissant un chemin d'écoulement pour qu'un fluide actif (5) se déplace entre la section d'entrée de chaleur (2) et les deux sections de sortie de chaleur (3a-b), la pluralité de canaux (4) étant dimensionnés de façon capillaire pour le fluide actif (5), des parois de la pluralité de canaux (4) entrant en contact avec la seconde surface (14) de la plaque de base (11),
**caractérisé en ce que**
la pluralité de canaux (4) est formée de tuyaux divisés en canaux (4) par des parois internes des tuyaux,
chaque section de sortie de chaleur (3a-b) comprend une chambre de liquide de refroidissement (6) entourant la pluralité de canaux (4) dans la section de sortie de chaleur (3a-b),
chaque chambre de liquide de refroidissement (6) comprend une entrée (7) et une sortie (8) pour un liquide de refroidissement (10) pour fournir une section refroidie par liquide de sortie de chaleur (3a-b),
l'entrée (7) et la sortie (8) pour le liquide de refroidissement (10) sont agencées sur des parois opposés de la chambre de liquide de refroidissement (6), dans lequel la pluralité de canaux (4) dans la section de sortie de chaleur (3a-b) sont agencés entre l'entrée (7) et la sortie (8) pour faire en sorte que la section de sortie de chaleur (3a-b) serve d'échangeur de chaleur à courants croisés.

2. Échangeur de chaleur selon la revendication 1, **caractérisé en ce que** la pluralité de canaux (4) dans les sections de sortie de chaleur (3a-b) comprennent des ailettes (15) s'étendant à partir de la surface extérieure de la pluralité de canaux (4).

3. Échangeur de chaleur selon la revendication 1 ou 2, **caractérisé en ce que** l'échangeur de chaleur (1) est adapté pour servir de caloduc pulsatoire.

4. Échangeur de chaleur selon l'une quelconque des revendications 1 à 3, **caractérisé en ce que** l'échangeur de chaleur (1) est adapté pour fonctionner avec une boucle fermée de fluide actif (5).

5. Échangeur de chaleur selon l'une quelconque des revendications 1 à 3, **caractérisé en ce que** l'échangeur de chaleur (1) est adapté pour fonctionner avec une boucle ouverte de fluide actif (5).

6. Échangeur de chaleur selon l'une quelconque des revendications 1 à 5, **caractérisé en ce que** la pluralité de canaux (4) sont agencés pour former un chemin d'écoulement en forme de serpentin pour le fluide actif (5) ayant un nombre de spires (20), et le nombre de spires (20) sont positionnées dans les deux sections de sortie de chaleur (3a-b).

7. Échangeur de chaleur selon l'une quelconque des revendications 1 à 6, **caractérisé en ce que** l'échangeur de chaleur (1) comprend une forme fléchie, dans lequel au moins une de la première section de sortie de chaleur (3a) et de la seconde section de sortie de chaleur (3b) est fléchie à l'opposé de la direction de longueur (L) de la section d'entrée de chaleur (2).

8. Échangeur de chaleur selon l'une quelconque des revendications 1 à 7, **caractérisé en ce que** la pluralité de canaux (4) dans la section d'entrée de chaleur (2) sont agencés pour recevoir de la chaleur à travers une surface de la pluralité de canaux (4), et la pluralité de canaux (4) dans la section d'entrée de chaleur (2) sont agencés pour rejeter de la chaleur à travers une autre surface de la pluralité de canaux (4).

9. Échangeur de chaleur selon l'une quelconque des revendications 1 à 8, **caractérisé en ce que** l'échangeur de chaleur (1) comprend une première section thermiquement isolée (17a) entre la première section de sortie de chaleur (3a) et la première extrémité (9a) de la section d'entrée de chaleur (2) et/ou une seconde section thermiquement isolée (17b) entre la seconde section de sortie de chaleur (3b) et la seconde extrémité (9b) de la section d'entrée de chaleur (2).

10. Utilisation de l'échangeur de chaleur selon l'une quelconque des revendications 1 à 9 dans un véhicule, **caractérisé en ce que** le liquide de refroidissement (10) comprend de l'huile pour moteur.
